# EUROPEAN PATENT APPLICATION

(11) **EP 2 884 338 A1**
(43) Date of publication of application: **17.06.2015**
(21) Application number: 13196937.0
(22) Date of filing: 12.12.2013
(51) Int. Cl.: G03F 9/00, G03F 7/20, G01B 9/02

(54) **Method of selecting a region of interest from interferometric measurements**

(71) Applicant: Mitutoyo Corporation, Kawasaki, Kanagawa 213 (JP)
(72) Inventor: Haitjema, Han, 5624 KP EINDHOVEN (NL); Quaedackers, Johannes Anna, 5508 LR VELDHOVEN (NL)
(74) Representative: EP&C

(57) **Abstract**

Method for determining a property of a surface of a sample from a correlogram obtainable by scanning of the surface of the sample through a focal plane of an objective while applying interferometry. The method comprising:
receiving data relating to a 3D image stack comprising of correlograms received on individual pixels of a 2D pixel array image sensor as a function of the scanning distance from the surface;
creating an average 2D image by averaging the correlograms for each pixel in the 3D image stack over the scanning distance;
selecting from the average 2D image the pixels of an area of interest;
calculating a derivative height independent property of the pixels of the area of interest; and,
determining a property of the area of interest of the sample from the derivative height independent property.

## Description

Method for determining a property of a surface of a sample from a correlogram obtainable by scanning of the surface of the sample through a focal plane of an objective while applying interferometry, the method comprising:
receiving a 3D image stack comprising of 2D images as a function of the scanning distance from the surface.

A correlogram displaying interference radiation intensity as a function of the scanning distance from the surface may be obtainable by interferometry, for example with a Mirau, Michelson and/or Linnik interferometer apparatus.

Such apparatus for determining a property of a grating (e.g. step height, film thickness, refractive index, pitch of a grating) of a sample may comprise:
an illuminator for providing an illumination beam;
a beam splitter for splitting the illumination beam in a reference beam for reflection on a reference reflector and a measurement beam for reflection on a surface of the sample;
a 2D detector for receiving an interference signal from the reflected reference beam from the reference reflector and the reflected measurement beam from the surface of the sample;
a scanning means for changing the distance between the surface of the sample and the apparatus; and,
a processing means for receiving a signal representing the interference radiation intensity received on the 2D detector from the detector and a distance signal from the scanning means and combining both to a received 3D image stack comprising of 2D images as a function of the scanning distance from the surface.

US8072611 discloses an apparatus to analyse unresolved grating structures. The apparatus has a light space modulator programmed for diffracting a light signal in order to generate at least two different diffracted beams that are not symmetrical relative to the lens optical axis, wherein the light space modulator includes a calculator adapted for applying a constant phase term to each of said at least two coherent beams.

The interference radiation intensity received on the 2D detector may be used to determine a property of the sample. The surface of the sample may comprise different areas with some of the areas being of interest while others are not. The areas of interest may comprise lateral unresolved features e.g. features that are relatively small such that they cannot be resolved with the interferometer apparatus. From the lateral unresolved features it may be still possible to determine properties of the features.

It is an objective to provide an improved method for determining a property of a sample from a correlogram with areas with lateral unresolved features.

Accordingly there is provided a method for determining a property of a surface of a sample from a correlogram obtainable by scanning of the surface of the sample through a focal plane of an objective while applying interferometry, the method comprising:
receiving data relating to a 3D image stack comprising of correlograms received on individual pixels of a 2D pixel array image sensor as a function of the scanning distance from the surface;
creating an average 2D image by averaging the correlograms for each pixel in the 3D image stack over the scanning distance;
selecting from the average 2D image the pixels of an area of interest;
calculating a derivative height independent property of the pixels of the area of interest; and,
determining a property of the surface of the area of interest of the sample from the derivative height independent property.

By selecting from the image the pixels of an area of interest the area of interest may be selected for determining a property of the area of interest. The signal of the individual pixels of the area of interest may be averaged to provide a robust signal, which may be used to determine a property of the unresolved features.

According to a further embodiment the image may be selected using pattern recognition to determine the area of interest. Hereby automatically an area of interest may be selected.

According to a further embodiment calculating a derivative height independent property of the area of interest comprises:
calculating a preliminary height independent property and determining of each pixel in the area of interest a deviation with respect to the preliminary height independent property and if the deviation is above a threshold ignoring the pixel in calculating the final derivative height independent property.

According to a further embodiment selecting from the average 2D image comprises ignoring pixels which are positioned along an edge of the area of interest. The pixels along the edge may deviate from the other pixels because edges may create different signals.

According to a further embodiment calculating a final derivative height independent property of the pixels of the area interest comprises autocorrelating the correlogram of each pixel with itself to calculate an autocorrelogram as a cross correlogram and calculating a final average correlogram from the autocorrelogram of each pixel. By averaging the signal will become more robust.

The original correlograms will be shifted with respect to each other if there is a height variation. If shifted correlograms are averaged there will be a fading of the signal intensity. Using the average auto correlation or the average spectrum will avoid this fading and thereby give better signal strength. As the surface height is eliminated by using the auto correlation or spectrum this height is no longer a fitting parameter and the fitting is less complicated.

According to a further embodiment the method comprises:
providing an illumination beam to the surface of the sample;
splitting the illumination beam in a reference beam for reflection on a reference reflector and a measurement beam for reflection on the surface of the sample with a beam splitter;
receiving an interference radiation intensity created between the reference beam reflected from the reference reflector and the reflected measurement beam from the surface of the sample on a 2D detector creating an interference signal;
scanning the surface with respect to the measurement beam in a direction substantially perpendicular to the surface over a distance while creating a distance signal with a scanner;
receiving the interference signal representing the interference radiation intensity received on the 2D detector from the detector and a distance signal from the scanner with a processor and combining both to a correlogram displaying a 2D interference radiation intensity as a function of the distance from the surface.

The method may comprise providing an illumination beam with a broad wavelength band. Broad wavelength band may be larger than 25nm, preferably larger than 50 and, most preferably larger than 100.

The method comprises providing an illumination beam with a narrow band. A narrow wavelength band may be smaller than 25nm, preferably smaller than 10 nm and most preferably smaller than 5 nm. The later may be useful for detecting unresolved features. The illumination beam may also be filtered with a filter to provide narrow band illumination. The narrow band illumination beam may be provided with a light emitting diode. Narrow band illumination has the advantage that the modelling may be simplified because no extra calculation for every separate wavelength may be necessary.

According to a further embodiment the method comprises filtering of the illumination pupil of the illumination beam. By filtering the pupil certain properties of the features will be better detected. Pupil filtering also gives the advantage that the modelling may be simplified because no extra calculation for every separate position in the pupil may be necessary.

According to a further embodiment the method comprises:
using two measurements with two different asymmetrical illumination pupils for the illumination beam to measure a property relating to asymmetry in the area of interest. By using the difference between the measurements one can determine a property of the area of interest of the sample from the final average correlogram.

According to a further embodiment calculating a final derivative height independent property of the pixels of the area interest comprises:
calculating a spectrum of the Fourier transform of the correlogram; and,
calculating a derivative height independent property of each pixel.

By calculating a spectrum it is possible to obtain a height independent property for each pixel as well.

According to an embodiment providing an illumination beam comprises providing an illumination beam with a plurality of discrete wavelengths. By providing a plurality of discrete wavelengths the measurement method may become more robust.

According to an embodiment filtering the illumination pupil may comprise filtering with an aperture blade, DMD, or LCD. This provides an easy way to adjust the illumination pupil.

According to yet a further embodiment the invention relates to a system for determining a property of a sample from a scan of a surface of the sample through a focal plane of an objective while applying broad-band interferometry as described above.

Embodiments of the invention will now be described, by way of example only, with reference to the accompanying schematic drawings in which corresponding reference symbols indicate corresponding parts, and in which:
Figures 1a and 1b depict Mirau interferometer system according to an embodiment;
Figure 2 discloses a Michelson interferometer system according to an embodiment;
Figure 3 discloses a Linnik interferometer system according to an embodiment;
Figure 4 discloses a schematic view of the data handling of a correlogram comprising 2D interference radiation intensity as a function of the scanning distance from the surface;
Figure 5 discloses a simple line space periodic structure (gratings) on top of a substrate with two layers; and,
Figure 6A and 6B disclose blades that may be used in the aperture of the illumination beam.

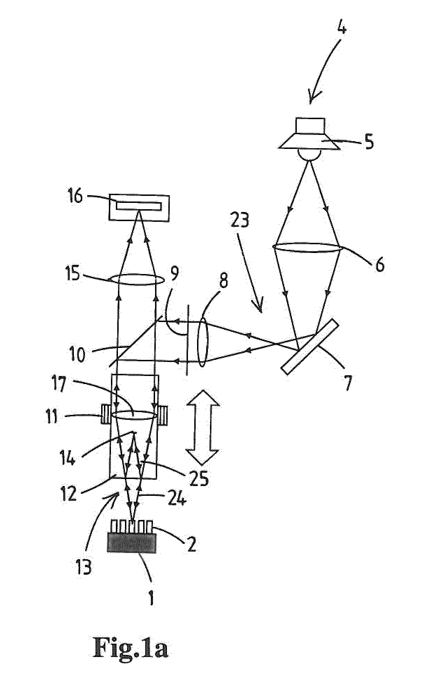

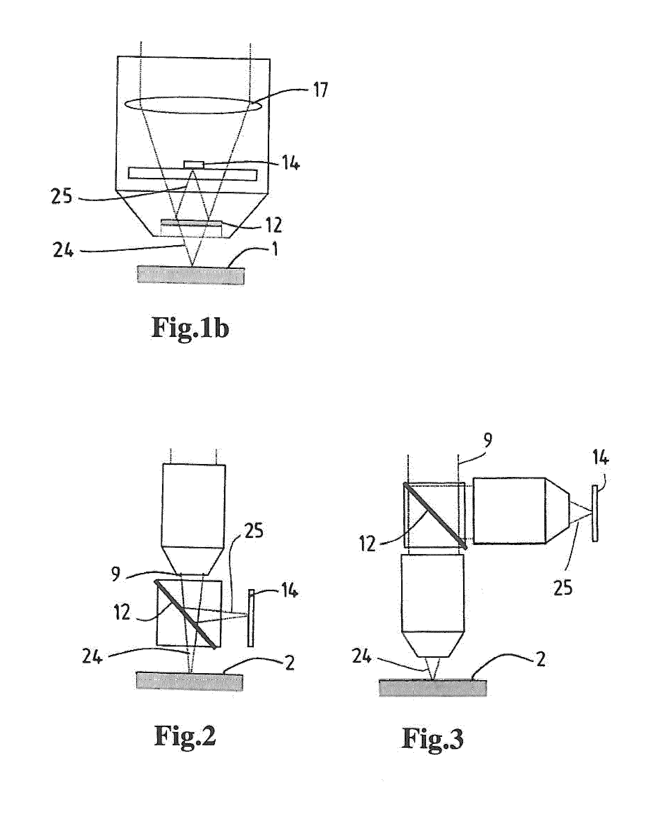

Figures 1a and 1b depict interferometer systems to measure a surface property of a sample 1 according to an embodiment. The measurement system comprises an interferometer apparatus, for example a Mirau interferometer apparatus 4, a Michelson and/or Linnik interferometer apparatus may also be used.

The apparatus 4 of figure 1 a and 1 b may comprise an illuminator 23 to provide a narrowband or broadband illumination beam. The illuminator may comprise a radiation source 5, a first lens 6, a first mirror 7 and a second lens 8, to provide the illumination beam. The illumination beam may be parallel. The illumination beam may be reflected on an illumination beam splitter 10 and traverse through an objective lens 17 before it reaches a beam splitter 12 for splitting the illumination beam in a reference beam 25 and a measurement beam 24.

The reference beam may be reflected on a reference reflector 14. The measurement beam may reflect from a surface of the sample 1 comprising under resolved feature 2. The beam reflected from the reference reflector 14 may reflect again on the beam splitter 12. The beam reflected from the sample 1 and the under resolved feature 2 may traverse through the beam splitter 12. The reference beam and the measurement beam may interfere and traverse through the objective lens 17, the illumination beam splitter 10 and a lens 15 to the detector 16. The intensity of the interference beam may be measured with the detector 16.

The reference reflector 14, the objective lens 17 and the beam splitter 12 may together form a Mirau objective and may be scanned optically with respect to the sample 1 along the optical axis and through the focal plane of the objective lens 17 with a scanner 11. A blade 9 may be provided in the illuminator 23 to filter the pupil of the illumination beam.

The interferometer apparatus may be, for example a Mirau interferometer (Figure 1), a Michelson interferometer (Figure 2) or a Linnik interferometer apparatus (Figure 3). The interferometer may be used to obtain a correlogram comprising 2D interference radiation intensity as a function of the scanning distance from the surface of the sample.

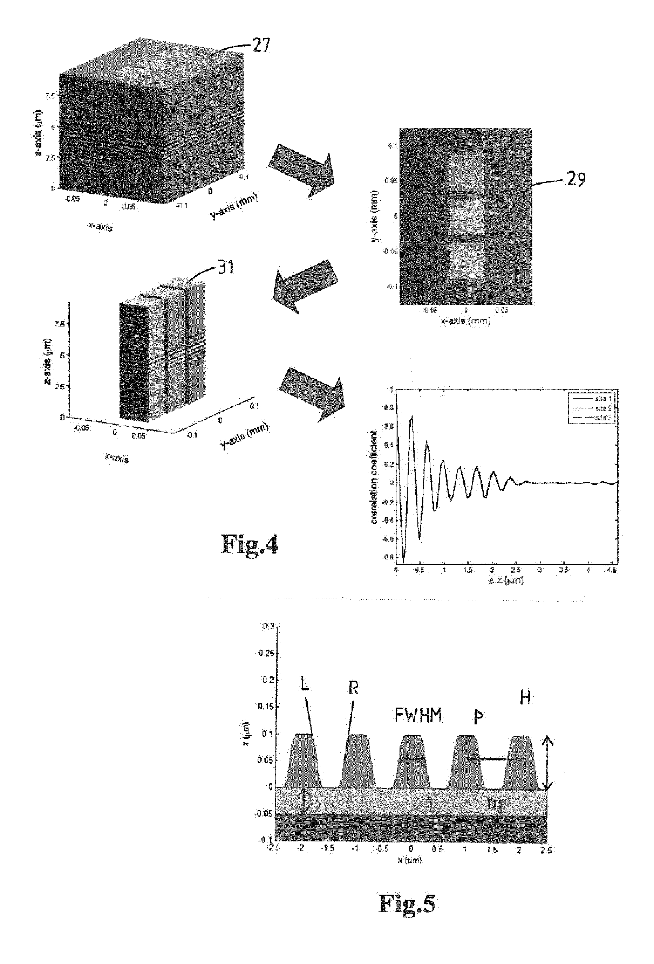

In figure 4 the pre-processing of measurement data is illustrated. First an image stack 27 may be acquired by a vertical (z) scan at a given location with a 2D pixel array image sensor. Next the average over all 2D interference radiation intensities over all scanning distances may be used to create an image 29 (the interference fringes are removed due to the averaging).

This image 29 may be used to select the pixels of the area(s) of interest, for example with pattern recognition software. See for example:http://en.wikipedia.org/wiki/Pattern_recognition. Of all areas of interest the final average of each pixel may be calculated 31, for example by autocorrelation of the correlograms. All auto correlograms of one area of interest may be averaged to reduce the statistical noise.

Deviating pixels may be excluded. This may be done by calculating a preliminary average autocorrelogram and determining of each pixel in the area of interest a deviation with respect to the preliminary average autocorrelogram and if the deviation is above a threshold ignoring the pixel in calculating the final average autocorrelogram.

The edge pixels may be down weighted to reduce edge effects. If the number of deviating pixels exceed a (user defined) threshold the final result may be flagged as false.

Next the auto correlograms may be compared to modelled auto correlograms to determine a property of the area of interest. RCWA, VIM, FEM, PSTD etc. may be used for modelling of the autocorrelograms. The comparison may be done using a non linear fitting algorithm such as: a Gaus-Newton, a Levenberg-Marquardt algorithm, a Simplex algorithm, or any other implementation.

However by its repetitive nature a look-up-table/search library approach may be more suited in case of many test sites. The latter however may be difficult to implement due to memory constrains. Using a sparse sampled LUT in combination with interpolation may solve this problem. See for example http://en.wikipedia.org/wiki/Kriging.

One may also use filtering of the pupil to reduce the number of calculations that are necessary in the model since for every direction a separate calculation may be necessary. By limiting the directions the number of calculations may be limited and the speed of the model may be increased. Filtering may also help to increase the sensitivity in the model.

For simple line space gratings the surface properties of interest are: pitch, left and right sidewall angles, step height, full width at half maximum, all film thicknesses, and the refractive indices of all materials. Other parameters sets that can be related to this set will also be applicable.

In case of an asymmetrical grating (the left and right side wall angle are different) one may need to combine two measurements with two different asymmetrical illumination pupils to solve the problem. The two different asymmetrical illumination pupils might be optimised to get the best sensitivity. The simplest variant would be to block the first half of the illumination pupil in the first measurement and block the other half in the second measurement. An aperture blade 9 may be used for this purpose.

Further, a liquid crystal display (LCD) or a digital mirror device (DMD) may be used to offer different illumination pupils. The LC and DMD are flexible in use because they can create any illumination pupil.

This principle works best if there are higher refraction orders captured by the optical system. One application of measuring asymmetrical gratings is to monitor the focus of a lithography process. To this end several marks have be proposed that produce asymmetrical gratings depending on the focus error during exposure. The benefit of our method is that it is possible to reduce the size of the test.

An auto correlogram may be used to reconstruct the unresolved features. As an example to explain our invention a simple line space periodic structure (gratings) on top of a substrate with two layers is shown in Figure 5. For simple line space gratings the surface properties of interest are: pitch P, left and right sidewall angles L, R, step height H, full width at half maximum FWHM, all film thicknesses n1, n2 , and the refractive indices of all materials. Other parameters sets that can be related to this set may also be applicable.

Except for a possible shift all pixels belonging to the same grating structure will have the same correlogram if the pitch of the periodic structure in any directions is smaller that the resolution limit of the optical system (no first order is captured by the optical system). A residual tilt after levelling the sample with respect to the optical system will cause a shift between the correlograms of individual pixels. This effect (height) may be removed by using the auto correlation of the correlogram instead of the correlograms. Averaging the correlogram directly will cause fading if the individual correlograms are shifted with respect to each other and thus will cause errors. As an alternative to our method the amplitude of the Fourier spectrum of the correlogram may be fitted.

If the light spot would be larger than the grating the reflected light ascending from areas outside the grating will distort the signal. Therefore pupil based or spectral based optical metrology methods require test structures that are larger than the projected light spot.

Image plane based methods have an advantage as they can use the image of the object. Image base technologies therefore enable to selects a set of pixels or even one pixel in the Field Of View for analysis. In image based metrology the test sites therefore can be substantially smaller than for spot based metrology. The only limitation to the test site size seems to be the number of periods required to ensure that the optically behaviour of the test site closely matches an infinite grating. A rule of thumb is that a few dozens of pitches is sufficient.

As the test sites can be quite small there might even be multiple tests sites in one field of view. This reduces the number 'move-focus-acquire' cycles to cover an entire sample e.g. a wafer and therefore can increase the number of measurements in a given time or reduce the require time for a given number of measurements. Pupil based optical metrology are generally very sensitive for defocus errors. Therefore, after moving from one to the next location a high precision (auto) focus procedure is required. Interferometry is by nature insensitive for defocus errors as long as the correlogram envelope is within the scan range.

In case of wafer metrology the sample is very flat compared to the required scan range of the interferometer. Therefore, there is no need to refocus between every step. Consequently, the number of focusing steps can be reduced substantially. Also the requirements for stage control are less tight in lateral (spot alignment) direction. Please note that a focus error in off-axis spectral based optical metrology results in a lateral shift of the beam spot.

In case of an asymmetrical grating (e.g. the left and right side wall angle are different) one needs to combine two measurements with two different asymmetrical illumination pupils to solve the problem. The two different asymmetrical illumination pupils might be optimised to get the best sensitivity. The simplest variant would be to block the first half of the illumination pupil in the first measurement and block the other half in the second measurement.

This principle works best if there are higher refraction orders captured by the optical system. One application of measuring asymmetrical gratings is to monitor the focus of a lithography process. To this end several marks have be proposed that produce asymmetrical gratings depending on the focus error during exposure. The benefit of our method is that it is possible to reduce the size of the test.

By using two overlay targets per direction in combination with an opposite and known overlay bias at the photo mask used it is possible to determine the overlay error by using the intensity difference (intensity asymmetry) between the two first orders (+ and -) in both measurements. See for example US 8339595 B2.

In interferometry one cannot directly measure the intensity asymmetry between the + and - first orders. However by blocking half of the illumination pupil one may measure indirectly this effect as the fringe contrast will be different depending on which half of the pupil is blocked. Thus this way an interferometer measurement system can be used to determine the overlay error. The benefit with respect to other overlay measurements systems is that overlay targets can be much smaller than the light spot if a method according to the invention is used.

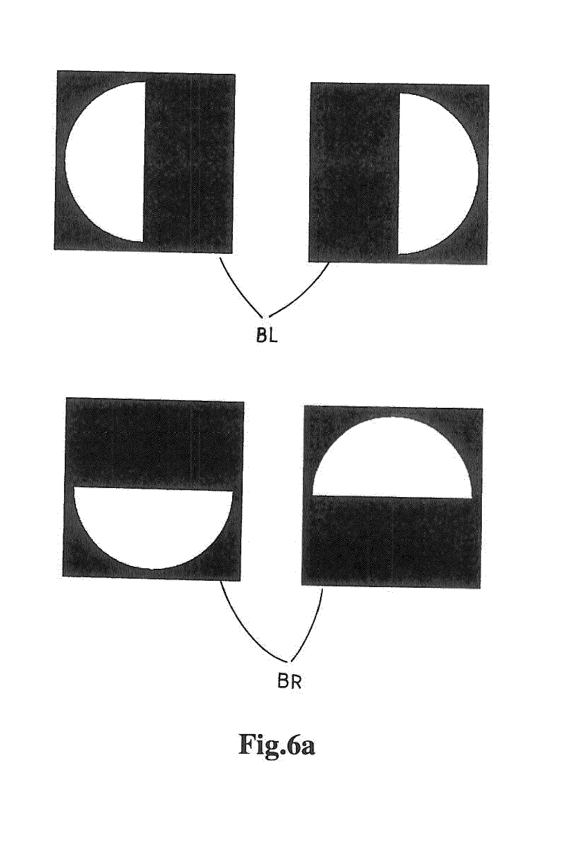

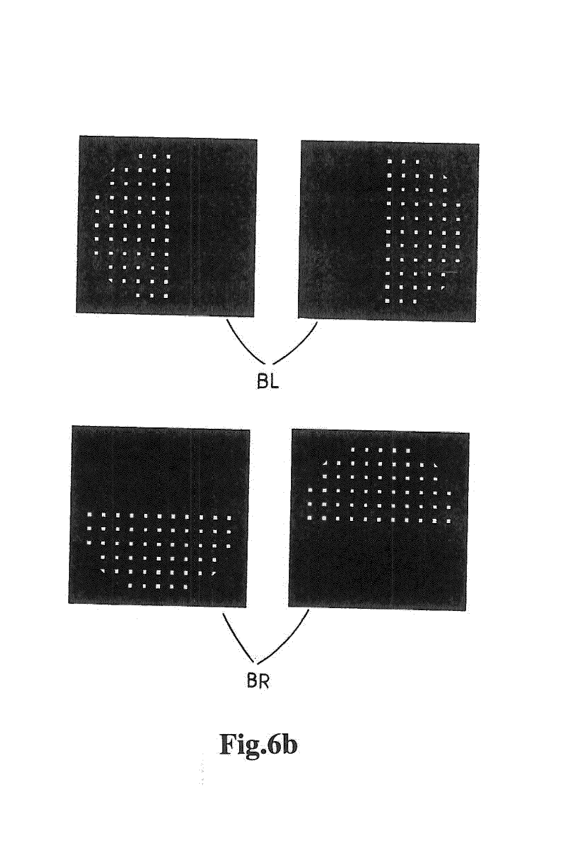

Aperture blades, liquid crystal displays (LCD) or digital mirror devices (DMD) may be used in the pupil plane (see figure 6A) of the illumination beam to enable asymmetric profile reconstruction and or overlay measurements. The two blades BL are to measure vertically oriented gratings. The two blades BR are to measure horizontally oriented gratings. Other kinds of asymmetric blades also are allowed (see figure 6B). The advantage of the discrete pupil filtering in figure 6B is that only a limited number of pupil positions are present making the calculation more easy. Again the pupil filter BL is for vertical structures in the under resolved features and BR is for horizontally oriented structures.

The method can be extended to analyse periodic structures with pitches slightly larger than the optical resolution. Thus the first or even second orders are captured by the optical system. In this case the auto correlograms of the pixels will no longer be equal. One can however still calculate the average auto correlogram and fit this using a physical model to extract parameters. In case of a finite number of pitches in the FOV or within the test site one has to take care of truncation effects at the edges. To reduce this effect one can gradually down weight the contribution of the edges. There are many types of filters to down weight the edges. For instance a Hann filter is a well suited filter for this purpose. However other similar filters are also appropriate. Down weighting the edges using filters is also recommended for sub resolution structures and film structures.

Off course the methodology to reconstruct gratings may also be applicable in absence of gratings. In other words one can use the same method/code to analyse (multi) film structures.

One may not directly measure the intensity asymmetry between the + and - first orders. However by blocking half of the illumination pupil one may measure indirectly this effect as the fringe contrast will be different depending on which half of the pupil is blocked. Thus this way a measurement system can be used to determine the overlay error. The benefit is that overlay targets can be much smaller than the light spot by selecting an area of interest from the complete area.

It is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Furthermore, the terms and phrases used herein are not intended to be limiting, but rather, to provide an understandable description of the invention.

The terms "a" or "an", as used herein, are defined as one or more than one. The term another, as used herein, is defined as at least a second or more. The terms including and/or having, as used herein, are defined as comprising (i.e., not excluding other elements or steps). Any reference signs in the claims should not be construed as limiting the scope of the claims or the invention. The mere fact that certain measures are recited in mutually different dependent claims does not indicate that a combination of these measures cannot be used to advantage. The scope of the invention is only limited by the following claims.

## Claims

1. Method for determining a property of a surface of a sample from a correlogram obtainable by scanning of the surface of the sample through a focal plane of an objective while applying interferometry, the method comprising:
receiving data relating to a 3D image stack comprising of correlograms received on individual pixels of a 2D pixel array image sensor as a function of the scanning distance from the surface;
creating an average 2D image by averaging the correlograms for each pixel in the 3D image stack over the scanning distance;
selecting from the average 2D image the pixels of an area of interest;
calculating a derivative height independent property of the pixels of the area of interest; and,
determining a property of the area of interest of the sample from the derivative height independent property.

2. The method according to claim 1, wherein selecting from the image comprises using pattern recognition to determine the area of interest.

3. The method according to any of the preceding claims wherein calculating a derivative height independent property of the area of interest comprises:
calculating a preliminary height independent property and determining of each pixel in the area of interest a deviation with respect to the preliminary height independent property and if the deviation is above a threshold ignoring the pixel in calculating the final derivative height independent property.

4. The method according to any of the preceding claims wherein selecting from the average 2D image comprises ignoring pixels which are positioned along an edge of the area of interest.

5. The method according to any of the preceding claims, wherein calculating a final derivative height independent property of the pixels of the area interest comprises:
autocorrelating the correlogram of each pixel with itself to calculate an autocorrelogram as a cross correlogram; and,
calculating a final average correlogram from the autocorrelogram of each pixel.

6. The method according to any of the preceding claims, wherein the method comprises:
providing an illumination beam to the surface of the sample;
splitting the illumination beam in a reference beam for reflection on a reference reflector and a measurement beam for reflection on the surface of the sample with a beam splitter;
receiving an interference radiation intensity created between the reference beam reflected from the reference reflector and the reflected measurement beam from the surface of the sample on a 2D detector creating an interference signal;
scanning the surface with respect to the measurement beam in a direction substantially perpendicular to the surface over a distance while creating a distance signal with a scanner;
receiving the interference signal representing the interference radiation intensity received on the 2D detector from the detector and a distance signal from the scanner with a processor and combining both to a correlogram displaying a 2D interference radiation intensity as a function of the distance from the surface.

7. The method according to claim 6, wherein the method comprises providing an illumination beam with a broad wavelength band.

8. The method according to claim 6, wherein the method comprises providing an illumination beam with a narrow wavelength band.

9. The method according to claim 8, wherein the method comprises providing an illumination beam with a narrow wavelength band with a light emitting diode.

10. The method according to any of claims 6 to 9, wherein the method comprises filtering the illumination pupil of the illumination beam.

11. The method according to any of the preceding claims, wherein the method comprises:
using two measurements with two different asymmetrical illumination pupils for the illumination beam to measure a property relating to a symmetry in the area of interest.

12. The method according to any of the preceding claims, wherein calculating a final derivative height independent property of the pixels of the area interest comprises:
calculating a spectrum of the Fourier transform of the correlogram; and,
calculating a derivative height independent property of each pixel.

13. The method according to claim 6, wherein providing an illumination beam comprises providing an illumination beam with a plurality of discrete wavelengths.

14. The method according to claim 10, wherein filtering the illumination pupil comprises filtering with an aperture blade, DMD, or LCD.

15. A system for determining a property of a sample from a scan of a surface of the sample through a focal plane of an objective while applying interferometry, the system using a method according to any of the preceding claims.
